# EUROPEAN PATENT APPLICATION

(11) **EP 4 155 820 A1**
(43) Date of publication of application: **29.03.2023**
(21) Application number: 21198307.7
(22) Date of filing: 22.09.2021
(51) Int. Cl.: G03F 7/20, G03F 7/00

(54) **REAL-TIME CONTROLLED AND VERIFIED MULTI-PHOTON LITHOGRAPHY**

(71) Applicant: Max-Planck-Gesellschaft zur Förderung der Wissenschaften e.V., 80539 München (DE)
(72) Inventor: PARKIN, Stuart S.P., 06118 Halle (DE); FARINHA, André Miguel Alves, 06114 Halle (DE)
(74) Representative: Schweitzer, Klaus

(57) **Abstract**

The present invention relates to an improved multi-photon lithography process, which allows verification and control of the result of the lithography process while the process is running (real-time verification and control) and optionally full 3D digital reconstruction of the final fabricated structure.

## Description

The present invention relates to an improved multi-photon lithography process, which allows verification and control of the result of the lithography process while the process is running (real-time verification and control) and optionally full 3D digital reconstruction of the final fabricated structure.

### Multi-photon lithography (MPL)

Multi-photon lithography (MPL) (also known as direct laser lithography or direct laser writing; see e.g.: Zwei-Photonen-Polymerisation zur Erzeugung mikrostrukturierter 3D-Freiformtargets für die Laser-Ionen-Beschleunigung. Technische Universität Darmstadt 2018; http://tuprints.ulb.tu-darmstadt.de/7677/1/Abel%20Juli%202018-.pdf) has matured into a diverse fabrication technique since its invention more than 20 years ago. It inherently offers unmatched 3D freeform fabrication from the meso- to the nano-scale, while being capable of achieving competitive fabrication rates (volume/min), high-resolution and small feature sizes. Over the last decade, it has enabled breakthroughs in many fields, e.g. in micro-fluidics and optics, which would not have been possible otherwise. It has achieved a widespread commercial success that continues to drive scientific and industrial innovation in many fields and its adoption rate keeps on increasing as the technique is further improved and adapted to new application workflows to achieve even better results.

Similar to other photolithography techniques, structuring in multiphoton lithography is accomplished by illuminating negative-tone or positive-tone photoresists via light of a well-defined wavelength. The fundamental difference is that the initiation step in MPL involves non-linear processes, thus enabling 3D fabrication. Due to the non-linearities involved in the process, MPL is able to manufacture objects smaller than standard lithography. The method relies on a multi-photon absorption process in a material that is transparent at the wavelength of the laser used for creating the pattern. By scanning and properly modulating the laser, a chemical change (usually polymerization) occurs at the focal spot of the laser and can be controlled to create an arbitrary three-dimensional periodic or non-periodic pattern. Recently, systems were built where several laser foci (usually generated from the same laser source) are used to pattern several copies of the same structure side by side or to make periodic structures.

Two-photon absorption is a third-order process with respect to the optical susceptibility χ⁽³⁾ and a second-order process with respect to light intensity. For this reason it is a non-linear process, which is several orders of magnitude weaker than linear absorption; thus very high light intensities are required to increase the number of such rare events. For example, tightly-focused laser beams can provide such intensities. Specifically, pulsed laser sources are preferred since they provide high-intensity pulses while depositing a relatively low average energy. To enable 3D structuring, the light source must be adequately adapted to the photoresist so that single-photon absorption is highly suppressed while two-photon absorption is favored. This condition is met if and only if the resist is highly transparent at the laser wavelength λ and, simultaneously, absorbing at λ/2. For the more general case of an n-photon absorption process, absorption is at λ/n with n≥2. As a result, a given sample can be scanned relative to the focused laser beam while changing the resist's solubility only in a confined volume. The geometry of the latter mainly depends on the iso-intensity surfaces of the focus. In other words, those regions of the laser beam which exceed a given exposure threshold of the photosensitive medium define the basic building block, the so-called voxel. Other parameters, which influence the actual shape of the voxel include the laser mode and the refractive-index mismatch between the resist and the immersion system leading to spherical aberration.

A general multi-photon lithography (MPL) workflow with a negative photoresist, which is the most commonly used photoresist, roughly comprises the following steps:
- Sample preparation: The 3D model to be fabricated is first decoded into an ordered series of paths or sets of positions to be described by the laser focus relative to the photoresist so as to faithfully replicate the mode! and its functionality. This also includes adjusting the fabrication settings (configuration presets) to be executed by the MPL setup, as for example the laser power and scanning speed.
   ∘ As an example, when one fabricates a replica, the model (which is to be replicated) is e.g. sliced along the z axis and for each slice the optimal route for the laser scan is computed based on the positions to be exposed or not; but also other parameters such as the laser power also play a role and have to be adjusted accordingly, e.g. with higher laser power one cannot put two passages of the laser very close together; even though the higher laser power results in a faster fabrication this is achieved at the cost of detail resolution.

Also, the substrate on which the photoresist will be cast, is cleaned and undergoes other typical application-specific preparation procedures before the photoresist, a viscous liquid in which the replica will be fabricated, is casted upon the substrate, usually through a simple drop-cast.
- Fabrication: With the predefined settings, the MPL setup executes the sequence of motions and laser exposures according to the structural digital decomposition. The volume of photoresist, which is exposed to a high enough laser dose undergoes polymerization, becoming hardened and insoluble (when using a negative photoresist). This polymerization only occurs in close proximity to the laser focus resulting in a precise control of the fabricated volume.
- Sample development: The substrate together with the exposed photoresist block is then immersed in an organic solvent, dissolving and washing away the unexposed photoresist (when using a negative photoresist), leaving a close replica of the desired model.
- Sample characterization (Optional): Since the size of the fabricated model is typically in the micro- to nano-range, the verification of whether or not (and if so, to what degree) the model has been correctly replicated/fabricated, is typically assessed in an optical microscope or a scanning electron microscope (SEM). For the latter the replicated model has to be coated with an electrically conductive material, e.g. gold or carbon before being characterized.

While configuration presets for different fabrication qualities - and, inversely, speeds - are made, these are typically only starting presets, which iteratively need to be tuned/adapted to the specific model either to achieve the best quality or the best speed or the best quality/speed balance.

The process of tuning the fabrication settings for a model or part of a model, with model/part of a model being a digital representation of the desired final physical result (the structure), consists of repeatedly fabricating the same structure yet under slightly different configuration presets in order to obtain an improved replica that most closely resembles the desired structure, and with the optimized settings being the ones that lead to that replica. After each fabrication the replicas are analyzed in the SEM, and their critical features - such as thin portions, complex details etc. - are measured and analyzed in detail in order to decide whether or not and if so which fabrication settings need modifications to improve identity of the replicas to the model.

### Stimulated Emission Depletion (STED) microscopy

Just as with confocal microscopy, MPL can achieve a higher resolution (super-resolution) through Stimulated Emission Depletion (STED). In STED, a second laser with an appropriate wavelength and a modified point-spread function (PSF), the so-called depletion laser, is superimposed to the first laser, the excitation laser, in order to inhibit the polymerization initiated by the latter. In the volume where the depletion laser PSF has close to zero intensity - usually the center - the polymerization reaction proceeds unaffected. However, in the region of space where both PSFs overlap, the depletion laser inhibits the start of polymerization. This effectively results in reducing the minimum achievable feature-size (i.e. the voxel) and resolution of MPL, with "resolution" being defined as the minimum distance over which one can resolve two closely fabricated structures or structure segments, and promotes a better aspect ratio for the voxel in the case of a 3D PSF configuration for the depletion beam.

### Problem underlying the Invention

Depending on the complexity of the model and the intended use, the above described state of the art MPL iteration process including the SEM analysis takes from a few hours to a full day, or even more in some cases. Yet, even when the optimization procedure is successful and has led to a satisfying replica the necessary coating for the SEM characterization usually impedes the replica's use.

It is also important to note that replica post-processing and characterization impacts the replica itself; it alters the fabricated structures. Among the more subtle impacts, the most noticeable are the shrinking of the fabricated structures, i.e. replicas, during the development step and the damage they suffer during SEM characterization. The shrinking is due to the increased density of the photoresist in solid form and is always to be expected to some extent, but its magnitude inter alia depends on the degree of polymerization, which partially depends on the fabrication settings.

The SEM characterization leads to structural deformation during the characterization, most likely due to heating effects from exposition to the electron beam. It has a greater impact on smaller replicas/structures, which can be seen to extensively deform in real time during SEM characterization. Thus, specifically in case of smaller replicas the characterization is a delicate and complex step since smaller features need a longer exposure to the electron beam in order to be better resolved. Yet, a longer exposure increases the damage to the structure and can easily lead to very significant imprecisions in the measurements/dimensions of small features.

Thus, with all the improvements and outstanding results that MPL has achieved so far, many of them had to rely on somewhat indirect measurements of the fabrication process, in the sense that the measurement can only take place after the fabrication is finished and the replica has undergone other preparation steps, which impact the replica themselves. Again, this is particularly important when a new model is to be fabricated: even similar, yet slightly different features or identical features on only slightly different locations in the structure require unique adjustments of the fabrication parameters in order to achieve optimum reproduction and only some of these parameters can be safely determined beforehand.

### Object of the Invention

It was, therefore, an object of the present invention to solve the above problems with state of the art MPL and to provide for an improved MPL process, which avoids or at least minimizes post process SEM characterization, and allows for a reliable control and verification of the MPL process while the MPL process is running (real-time control/verification). It would further be advantageous to tune the fabrication settings for a model or part of a model while the MPL process is running. Moreover, it was an object of the present invention to provide for full 3D digital reconstruction of the final fabricated structure.

### Brief Description of the Invention

The above problems are solved by a Multi-Photon Lithography process, which comprises
- directing and guiding a beam of an excitation laser into and through a volume of a photoresist in order to trigger a polymerization process in the volume of the photoresist which has been affected by the beam of the excitation laser, wherein the photoresist comprises a light-emitting material that is sensitive to changes in the volume that occur during photo-polymerization;
- scanning the volume of the photoresist which has been affected by the beam of the excitation laser and its vicinities, between 0 and 10000000µs, preferably 100 and 400000 µs, most preferably between 200 and 100000 µs after excitation with the excitation laser, with a second laser, thereby triggering the emission of light signals in the volume of the photoresist which has been affected by both lasers, and
- determining/inferring the volume of polymerized photoresist based on the intensity of the emitted light signals.

Specifically, the invention concerns a real-time controlled and verified Multi-Photon Lithography process, comprising of the steps:
a) providing a representation of a model to be replicated;
b) deconstructing the model to be replicated into a layer- or path-based representation;
c) providing a first set of values for the Multi-Photon Lithography fabrication parameters;
d) providing a photoresist casted or coated onto a substrate, thereby providing a volume of the photoresist wherein the photoresist comprises a light-emitting material, that is sensitive to changes in the volume that occur during photo-polymerization;
wherein the sequence of steps a)-d) can deliberately be changed;
e) using the layer- or path-based representation of the model and the first set of values for the MPL fabrication parameters to direct and guide a beam of an excitation laser into and through the volume of the photoresist in order to trigger the polymerization process in the volume of the photoresist which has been affected by the beam of the excitation laser;
f) scanning the volume of the photoresist which has been affected by the beam of the excitation laser in step e) and its vicinities, between 0 and 10000000µs, preferably 100 and 400000 µs, most preferably between 200 and 100000 µs after excitation with the excitation laser, with a second laser, thereby triggering the emission of light signals in the volume of the photoresist which has been affected by both lasers,
g) registering the light signals together with at least the coordinates of their location of emission yielding in registered light signal data;
h) determining/inferring the volume of polymerized photoresist based on the intensity of the registered light signal;
i) comparing the volume of polymerized photoresist determined in step h) with the corresponding volume in the layer- or path-based representation of the model, resulting in a satisfactory or a non-satisfactory reproduction of the volume;
j) adjusting the first set of values for the MPL fabrication parameters if the comparison in step i) is non-satisfactory, yielding in an adjusted set of values for the MPL fabrication parameters; or maintaining the first set of values for the MPL fabrication parameters if the comparison in step i) is satisfactory;
k) recursively performing steps e)-j) with either the adjusted set of values for the MPL fabrication parameters or the maintained set of values for the MPL fabrication parameters and the next incremental data set of the representation of the model adjacent to the data set just previously replicated so as to progressively direct and guide the beam of the excitation laser into and through the volume of the photoresist until the model has been replicated.

The invention further comprises a data-driven full 3D reconstruction and modelling of a multi-photon lithography fabrication process, comprising the following steps:
i. loading characterization light signal data acquired during the recursive registration in step g) of the above process steps e) through j) for a model;
ii. determining points where the polymerization process was started in step e);
iii. determining/inferring the total polymerized volume, accounting for proximity effects of several polymerization starting points on the same region in step e);
iv. identifying points where the polymerization did not occur to a sufficient extent to generate the desired geometry or led to weaker regions in the final structure;
v. reconstructing the model of the final replicated model in step k) above, based on the analysis on iv.) by generating a 3D map of fabricated points and reconstructing a mesh over these points;
vi. identifying and interpreting common light signal responses and their common progression over several layers or path-based representations in step f) above and evaluating the results of the correction strategies applied to the set of fabrication parameter values;
vii. identifying/determining fabrication characteristics such as diffusion lengths, aspect ratio and others and tune/generate new deconstruction algorithms to account for such characteristics and ensure better fabrication fidelity and reproducibility of the 3D replica.

### Description of the Figures

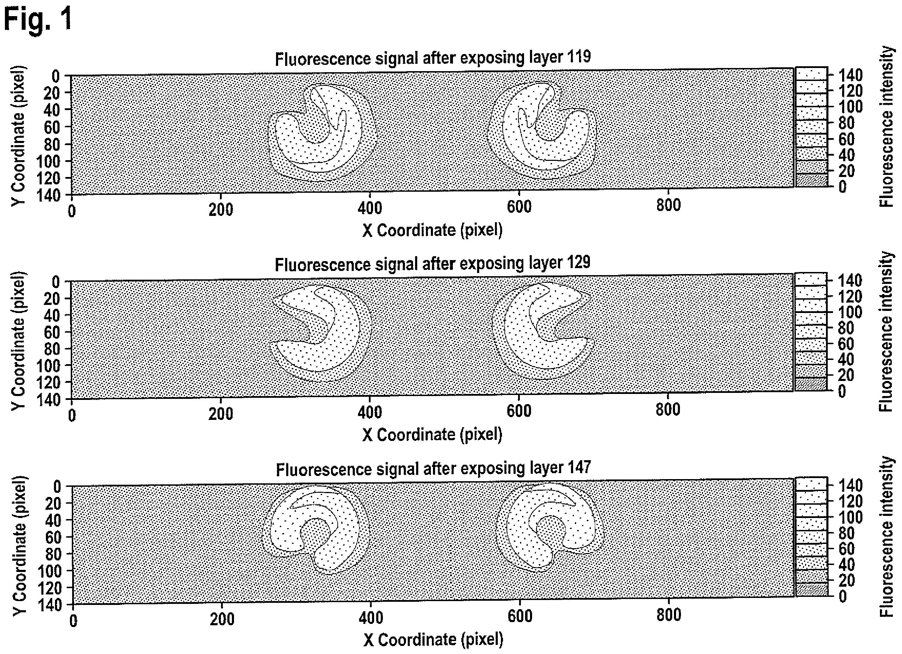

Figure 1 shows the application of the real-time verification. Displayed is a case where a double-coil is being fabricated (one on the left side and one on the right side). The inner and outer circumferences are supposed to be circular. The exposed shape should be the same in every layer but rotated around the central axis.

The top-most plot represents the fluorescence signal of a layer at a lower height (layer 119), where the laser dispersion is not yet significant enough to impact the polymerization process.

In the middle plot, corresponding to the fluorescence signal of another layer (layer 129) 250nm above the first image. In this layer (129) the laser has to go deeper into the photoresist in order to polymerize. One can already note that the fluorescence intensity of the inner sections is significantly smaller than in the top-most plot. This is so because the laser disperses more as it goes deeper into the material and deposits less energy, impairing the start of the polymerization process. This decrease in fluorescence was detected and, once the fluorescence signal went below a given threshold, the laser power and scanning speed were slightly modified to compensate for the increase in dispersion.

After this compensation of the set-up, as seen in the bottom image, which represents a layer 450nm above the second image (layer 147), the fluorescence signal is seen to recover to the same average value as in the top-most image (layer 119).

In the end, while such structures without any compensation would eventually fail because the polymerization stops at a certain height, compensating the laser power and/or scanning speed based on the fluorescence signal acquired in this manner enables one to produce the complete structures.

It has also been noticed that the fluorescence signal drop is structure dependent, which makes sense given that different structures would disperse the laser beam differently and thus require compensation at different points. Also, such a structure dependent dissipation can be corrected with the real-time verification process according to the invention.

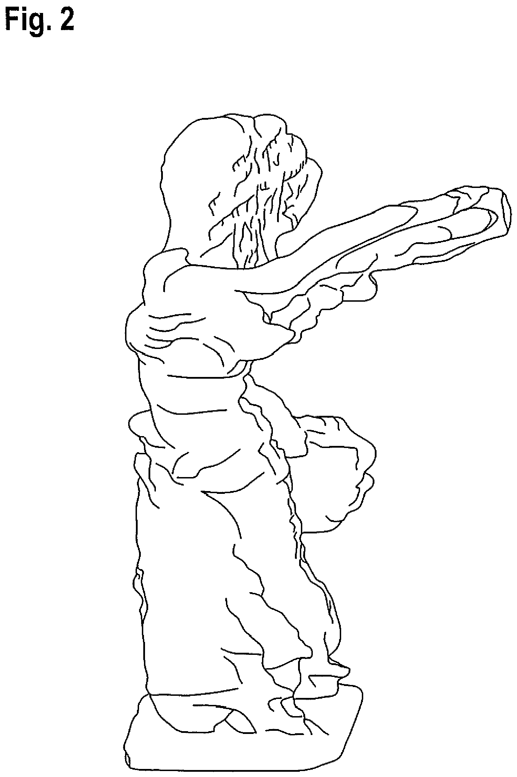

Figure 2 shows an outer 3D mesh of a fabricated structure. The fluorescence data acquired during the modified fabrication process is stored after the fabrication. These data correspond to the layer-by-layer fluorescence signal acquired shortly after exposition with the excitation laser. Since each layer corresponds to a well-defined height above the substrate, it is possible to stack all this data and extract a 3D model of the final fabricated structure.

Starting from the fluorescence data acquired during the modified fabrication (in the real-time verification process), a fluorescence threshold is defined to select only the regions where the fluorescence intensity surpasses such value in each layer, as these are the regions most likely to have undergone polymerization. Given that each XY pixel and each Z layer index can be traced to physical positions, this results in a 3D set of points where the fluorescence signal is correlated to the occurrence of polymerization. Each of these points is slightly expanded in XY and Z (the voxels are ellipsoids elongated in Z) to compensate for the voxel expansion due to the polymerization chain reaction.

From the expanded set of 3D points, one can apply a surface reconstruction algorithm in order to generate an outer 3D mesh of the fabricated structure, as seen in Fig. 2.

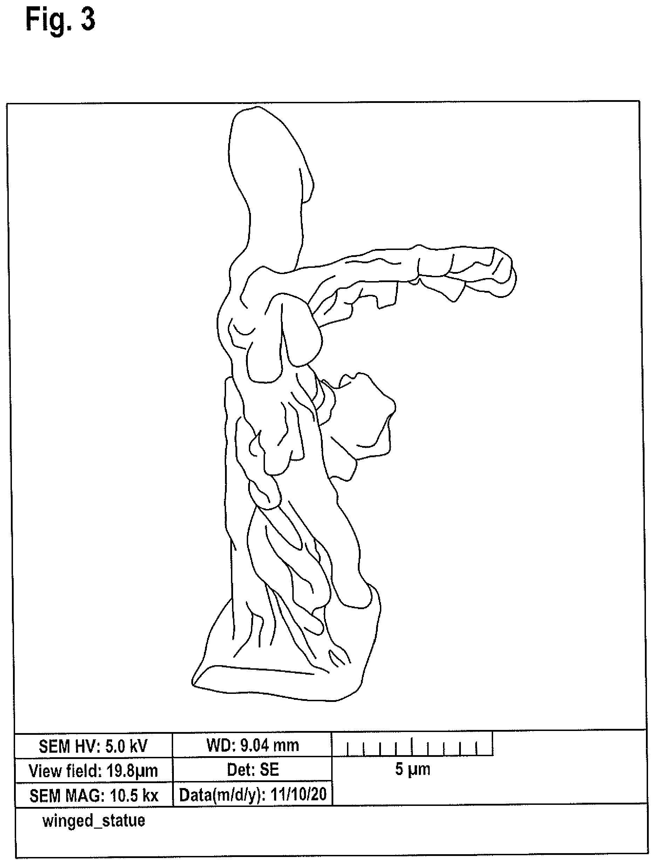

Figure 3 represents the SEM characterization of the same structure as in Fig. 2. During the SEM characterization, however, the structure was observed to deform, particularly the wing on the right, which was seen to bend into the position seen in the image.

The mesh resulting from the 3D reconstruction (Fig. 2) not only enables the evaluation of the structure from any perspective, but it also enables the measurement of the distance between any two points in the resulting structure, which is not always possible and/or easy to do in the SEM (Fig. 3).

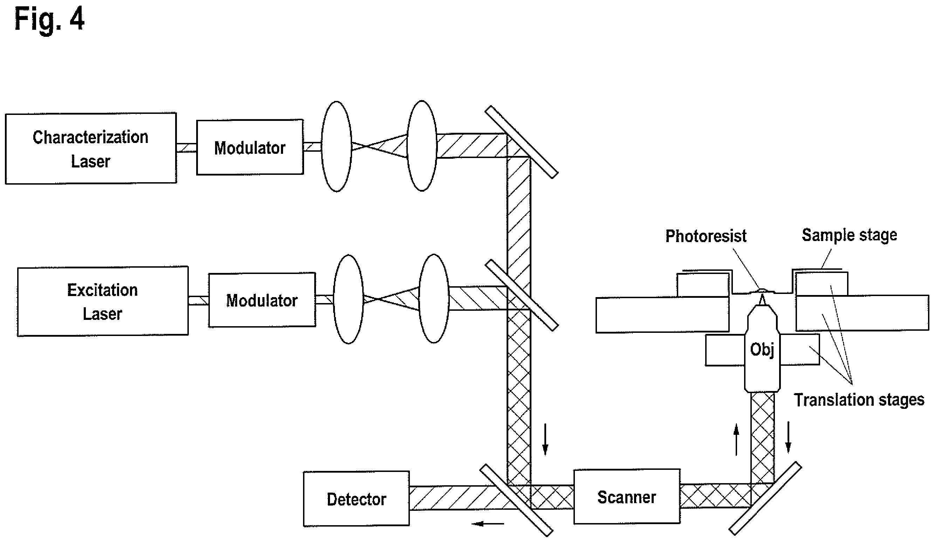

Figure 4 shows a Setup diagram of the MPL equipment used in the present invention. Modulators are utilized to control whether the laser power goes into the sample (photoresist), and, if it does, the percentage of laser power passing through. The detector is used to register the fluorescence signal. The scanner, along with the translation stages, are used to move the sample with regard to the laser focus. The sample stage fixes the sample (photoresist) to the translation stages.

### Detailed Description of the Invention

In general, the invention refers to a Multi-Photon Lithography process using a photoresist, which is a monomer or oligomer/photo-initiator composition, which is polymerizable under the effect of a laser of an MPL assembly upon activation of the photo-initiator. In order to observe and characterize the polymerization process as proposed in the present invention, the photoresist must comprise a type of light-emitting material, preferably a fluorophore, that is sensitive to changes in the photoresist medium that occur during photo-polymerization, e.g. changes to the mechanical properties.

It has been observed that, by scanning a second laser, the characterization laser, over a region which contains areas which have been exposed to the excitation laser up to several minutes before, it is possible to observe an increase of up to approximately 10x in the light signal intensity, preferably the fluorescence signal, of the areas sufficiently exposed to the excitation laser (compared to the areas which have not been, or at least not sufficiently, exposed to the excitation laser, i.e. which have only been exposed to the characterization laser). Without wishing to be bound by this theory, it is believed that this increase is attributed to the change in the electronic ground state of the photo-initiator molecule, either caused by a change in the molecule itself or the surrounding medium, under the polymerization process.

Unfortunately, the polymerization occurrence cannot generically be linked to a certain fixed level (threshold) of fluorescence for all polymerization inducing exposition conditions; nevertheless, such a threshold can be defined for a specific set of exposition conditions, thereby enabling the approach of the present invention:
By determining and defining the light intensity, preferably the fluorescence intensity, that corresponds to the polymerization threshold (the minimum exposure dose leading to appreciable polymerization) for a given set of exposition conditions, it becomes possible to assess where the polymerization is occurring and where it is not.

The excitation laser power and the scanning speed, among other exposition conditions such as the focal spot size, define the exposition dose, i.e. the amount of energy deposited per volume element. It thus directly affects the size of the minimum fabricated feature, the voxel.

In the present invention the changes induced by the excitation and polymerization processes (caused by the excitation laser) to the light, preferably fluorescence, absorption and/or emission of the photoresist components are utilized to characterize the multi-photon lithography fabrication process with the aid of the characterization laser in real-time or near real-time with high-resolution, and possibly even super-resolution, and this characterization is used to adjust the MPL fabrication parameters on-the-fly in order to improve the replication quality of the desired model.

Since the execution of the multi-photon lithography process is time consuming, usually involving scanning more than hundreds of thousands of lines or positions over hundreds and even thousands of layers or other equivalent partial representation components, the expenditure of time for any new, additional step, such as the scanning of the layer or component with the characterization laser and the processing of the resulting data, is cumulative and it will add significant time to the fabrication process, possibly make the process impractical or even unfeasible, specifically for a scaled up manufacture for high numbers of replicas. Therefore, and although the impact varies for different fabrication processes, it is desirable to speed up the data processing step, which should not take longer than a few tens of milliseconds so as not to greatly impact the overall fabrication time. Moreover, it has to be taken into account that, in the above described real-time characterization process, only partial characterization data is available, since not all of the contiguous layers or components of a given layer or other equivalent component can be accounted for because they are yet to be exposed. Typically, it is not possible to account for the effect of layers above a layer, which is just characterized because this layer is yet to be exposed. Therefore, it is beneficial to minimize the duration of the real-time analysis, typically by minimizing the amount of characterization data - usually only that of a given layer or representation component - and/or the complexity of the analysis for the real-time characterization and parameter control.

While this alleviates the impact on the fabrication time, it is carried out at the expense of some errors by not accounting for all proximity effects between contiguous layers or representation components. Yet, once the fabrication of a replica is finished, the data for all the fabricated layers or components are available and the processing time is no longer a factor. This means that the characterization data can now be processed to increase precision, accounting for proximity effects and generating even more reliable results, which can then be used to improve future, maybe even up-scaled, fabrication processes. Therefore, in a further embodiment the present invention also provides a solution for increased replica precision by using the data acquired during the above described real-time improved fabrication in a data-driven automated reproduction process for high-resolution 3D samples.

By calibrating the light (preferably fluorescence) emission to the occurrence of photo-polymerization and/or degree of photo-polymerization under a predefined fabrication condition, which can be accomplished through fabrication of several slightly different structures and posterior comparison between the acquired characterization signals and the characterization through high-resolution methods such as scanning electron microscopy, it becomes possible to assess which areas were fabricated just less than milliseconds after their laser-exposition, through one of several analyses such as defining a local intensity or increment threshold for the acquired signal to consider that a given region or volume has undergone sufficient polymerization. Such a "live inspection" of the fabrication process can be used to automatically adjust fabrication parameters on-the-fly.

### Definition of terms

A "model" is the digital representation of the 2D or 3D structure that is to be transferred to the photoresist. It is the 2D- or 3D-input of the process and defines its (the process') desirable outcome. The fabrication process aims at replicating the model as closely as possible, but it is limited by voxel size, the resolution, and specifics of the fabrication process such as diffusion of the polymerization chain-reaction or shrinking during development.

A "sample" comprises the set of material components, which are required to achieve and constitute the final result of the fabrication process. A sample is, generally, composed of the fabrication substrate and the material, which will be worked on, i.e. the photoresist. Any further material deposited onto or used together with the photoresist is also considered part of the sample. The immersion oil used between the objective and the substrate can also be considered part of the sample, although its presence is only temporary. The sample is, essentially, the set of consumable materials needed to perform a fabrication sequence and, at the same time, is also the end result of the process.

"Replica" is the replicated model, i.e. the result of the MPL fabrication process.

"Structure" is a physical three-dimensional object or a part of it. Although it refers to an object in the physical sense, it is also used in the context of being the idealized physical result of the fabrication process, disregarding physical limitations such as resolution and others, and therefore can be used interchangeably with the term 'model' in the context where it means the idealized outcome of the fabrication.

"Deconstructing" or "slicing" the model means decomposing a 2D or 3D model into a set of partial representations in fewer dimensions that are optimized for the fabrication process, with each partial component of the model being represented by a data set that can be read and executed by the fabrication setup/equipment (for example a sequence of XYZ coordinates with associated laser settings). Such a 2D or 3D representation is one of several possible ways to encode a 2D or 3D shape and to store the data into an electronic file. Typical file types used to store 2D or 3D objects are "stl", "obj", etc. Typical file types used to store deconstructed 2D or 3D objects are, for example, "gcode" and similar.

By extension, a 'deconstruction algorithm' is a computation process which, based on a simplified set of user inputs, is able to convert a general 2D or 3D model of a structure into a set of partial representations in fewer dimensions that is optimized for fabrication.

"Representation of the 2D or 3D model" or "representation of the model" is the collection of all data sets of all partial segments of the model utilized for the replication of the model according to the fabrication method.

A "set of values" comprises all the parameters that need to be defined for the correct operation of the fabrication equipment and correct execution of the fabrication process. While most of these values are generic and typically need not be changed for different fabrication processes, e.g. the number and length of steps with which the translation stage approaches the objective while finding the substrate interface at the start of the fabrication, others are closely related to the desired structure and the fidelity or detail of its fabrication and need to be adjusted accordingly, e.g. excitation laser intensity (power) and laser scanning velocity (speed).

"Correction strategy" refers to the different ways mismatches between the replica and the desired model are addressed in terms of which fabrication parameters to change and/or how much to change them by. As an example, if the fabricated volume of a segment of the replica is determined to be significantly smaller than that of the equivalent model segment, it is possible to increase the exposition energy either by increasing the laser power, decreasing the scan speed or do both simultaneously, resulting in three different correction strategies that can be taken, for example, in step (j) of claim 1.

"Fabrication characteristics" are quantities associated to the physical phenomena occurring during fabrication that impact the fabrication result but which are difficult to quantify directly, either because they are associated with dynamical phenomena, such as diffusion lengths, or because they can be impacted during fabrication, such as the impact of diffusion and aberrations on aspect ratio when the laser is focused deep into the sample.

A "photoresist" can either refer to a positive or negative photoresist and constitutes the fabrication medium, i.e. the material to be modified during the fabrication. A negative photoresist (used for radical photo-polymerization) is composed of a monomer- or oligomer-based compound with radical photo-absorbing/initiator components that will generate a free-radical to initiate the chain reaction mediated by the free-radical transfer within the monomer or oligomers. In this process, the sufficiently exposed material becomes insoluble in the development step.

A positive photoresist (used for cationic photo-poiymerization) is usually composed of an epoxide-based formulation and cationic photo-absorbing/initiator components that will generate strong acids to initiate the chain reaction mediated by charge transfer within the (usually) epoxide-based material. In this process, the sufficiently exposed material becomes soluble in the development step.

Several different implementations are possible in both cases, e.g. with the monomer-or oligomer acting as photo-absorbing component or with several co-initiators where one is the photo-absorbing component and the other is the component responsible for radical/acid generation, but the functional components are constant in both photoresist types: a photo-absorbing component, a radical/acid generation component and a component to fuel the chain reaction.

It is essential that the photoresist comprises a light-emitting material, preferably a component or compound with a fluorophore group, so that the photoresist is capable of generating a signal, and that this light-emitting material is sensitive to any of the changes to the local medium/environment that occur during the polymerization process, so that a signal which is specifically related to the occurrence of photo-polymerization is generated/available.

An example photoresist, which can be used in the present invention, is a photoresist where 7-Diethylamino-3-thenoyl-coumarin (DETC) is used as photo-initiator with Pentaerythritol triacrylate (PETA) being used as polymerizable monomer. However, it will be apparent to those skilled in the art, that besides DETC many other fluorescent compounds, including other coumarins, can be used (see e.g. W. F. Jager, A. A. Volkers, and D. C. Neckers, "Solvatochromic Fluorescent Probes for Monitoring the Photopolymerization of Dimethacrylates," Macromolecules, vol. 28, pp. 8153-8158, Nov. 1995. Publisher: American Chemical Society; or B. Strehmel, J. H. Malpert, A. M. Sarker, and D. C. Neckers, "New Intramolecular Fluorescence Probes That Monitor Photoinduced Radical and Cationic Cross-Linking," Macromolecules, vol. 32, pp. 7476-7482, Nov. 1999. Publisher: American Chemical Society) which exhibit polymerization sensitive fluorescence, in such a way that a different fluorescence signal can be registered depending on whether it is emitted from a polymerized or non-polymerized region. Some of these fluorescent compounds exhibit this behavior even under cationic polymerization conditions (see W. F. Jager et al., supra). A few examples of such fluorescent compounds besides 7-Diethylamino-3-thenoyl-coumarin (DETC) are trans,trans-1,4-bis[2-(2',5'-dimethoxy)phenyl-ethenyl)-2,3,5,6-tetrafluoro-benzene, trans,trans-1,4-bis-[2-(3',4',5'-trimethoxy)phenylethenyl)-2,3,5,6-tetrafluorobenzene, trans-2-(2',5'-dimethoxyphenyl)ethenyl-2,3,4,5,6-pentafluorobenzene, trans-2-(3',4',5'-trimethoxyphenyl)ethenyl-2,3,4,5,6-pentafluorobenzene, (see B. Strehmel et al., supra), 7-(dimethylamino)-4-(trifluoromethyl)coumarin, N,N-di-n-butyl-5-(dimethylamino)-1-naphthalenesulfonamide, 4-(dimethylamino)-4'-(methylsulfonyl)stilbene, 4-(dimethylamino)-4'-(methylsulfonyl)diphenylbutadiene, and 4-dimethylamino-4'-nitrostilbene (see W. F. Jager et al., supra). B. Strehmel et al. and W. F. Jager et al. provide evidence that these and similar fluorescent compounds may exhibit at least the same behavior as DETC, maybe even with better performance than DETC, i.e. better fluorescence signal to noise ratio, so that they might be used instead of DETC in other photo-resist formulations.

The polymerizable monomer is not critical and it can reasonably be assumed that any photo-resist combination comprising a fluorescent compound which exhibits the above described function, and which is used as a photo-initiator, co-initiator or simply as non-interfering fluorophore, will provide the same process and advantages of the herein described invention. The current invention is widely compatible with many types of photo-resist formulations as long as the fluorescent compound exhibits polymerization sensitive fluorescence, in such a way that a different fluorescence signal can be registered depending on whether it is emitted from a polymerized or non-polymerized region.

A "substrate" is a physical element that supports or holds the fabrication medium, which is the material to be modified during the fabrication. For the fabrication to occur the excitation laser has to be scanned/moved relative to the fabrication medium, which is usually a viscous or highly deformable material. The substrate provides a rigid platform where the fabrication medium can be placed upon as well as establishing connection to the equipment sample stage, i.e. the platform where the sample is fixed to the translation stage.

A "MPL excitation beam" or "excitation beam" is a - preferably pulsed - beam of laser light at a predefined wavelength, energy and irradiance that matches the parameter region of the fabrication medium where the two-photon absorption occurs, e.g. a 780nm wavelength fs-laser with few tens of mW average power at the sample for a DETC/PETA photoresist, promoting the desired modification of the fabrication medium without leading to its uncontrolled ablation. Preferably the MPL excitation beam is formed as a train of modulated laser pulses with the capability to modulate the laser energy, and optionally the capability to modulate the pulse rate and/or pulse length, both of which can be defined and set at a modulator element either in or past the laser source (see Figure 4). While it is generally possible to direct more than one excitation laser beam into the photoresist, e.g. if simultaneous production of identical objects in two or more different locations of the photoresist is desired (side-by-side or parallel production), the typical, and thus preferred, mode of operation is to use only one MPL excitation beam.

A "characterization laser" or "characterization laser beam" is a pulsed or continuous wave beam of laser light at a predefined wavelength (see reference MPL excitation beam above) energy and irradiance that is able to promote photon emission, preferably through excitation of a fluorescent transition, in the photoresist volume that was excited and modified by the excitation beam shortly before it is irradiated with the characterization laser. Preferably, the MPL characterization beam is formed as a train of modulated laser pulses, in order to avoid excessive excitation, thereby causing a delay in the signal bleaching. The characterization beam optionally has a modulated rate and/or a modulated length, which can be defined and set at a modulator element either in or past the laser source (see Figure 4).

"MPL setup" means the equipment, which is used for the purpose of executing, controlling and coordinating all the steps which are necessary for performing an MPL fabrication process, e.g. performing the mechanical movements in order to execute predefined motions (e.g. of the laser with regard to the sample) or laser shutters for executing sequential openings and closures in order to only expose the correct part of the sample.

"Vicinity/ies" means a spheric or ellipsoidal volume (depending on the specific context, so as to better approximate the voxel aspect ratio) of 1-3 times, preferably 1-5 times, more preferred 1-9 times the voxel volume in nm³ around a point of origin, e.g. defined by its coordinates x, y and z. The definition is set according to the voxel volume so as to account for the usage of lower numerical aperture lenses, which enable faster fabrication at the cost of increased feature size and decreased resolution.

"Registering" or "Acquiring" means the physical acquisition of an (analog) signal, and its transduction into a digital signal. It is usually applied in the context of the acquisition of fluorescent signals.

"Storing" or "Saving" refers to storing data on a data carrier or in a volatile memory device.

"Determining" means the extraction or calculation of a new quantity or property from a set of data, which includes all the necessary parameters for the precise attribution of a value to this new quantity or property. It might take into account the measurements performed during the experiments, precise quantifications performed previously, e.g. through calibrations, or the precise knowledge of the effects ruling the conversion of the acquired data to the final quantity

"Inferring" means the extrapolation or estimation of a new quantity or property from a set of data, which does not enable the explicit extraction of such quantity. It is done by assuming or approximating extra information from the underlying physical process or previous calibrations of the system.

### Detailed description of the process with real-time verification and control

In the first steps (a) and (b) a model to be replicated is provided and "deconstructed". In the deconstruction the model is sliced or decomposed in a number of coplanar layers or a set of 3D lines with information of the intersection of each of these layers or lines and the desired model and the distance between the layers in the former case. While this is the preferred deconstruction for the present invention, the model to be reproduced may also be decomposed into segments, i.e. partial models. To determine the segments, the overall model to be reproduced is preferably screened by computation, in particular, decomposed in volume elements or "voxels" and the segments, or partial models, are each formed by a preferably contiguous set of voxels. In this respect, a segment is composed of a set of shape-like or shape-identical volume elements (voxels). In principle, the breakdown of the overall structure into multiple segments is preferably carried out by software engineering and computer. In this respect, a data set representing the overall structure (for example CAD data), i.e. the 2D or 3D model, is provided and, if appropriate, stored on a data carrier or in a volatile memory device. From this, further data sets are determined by computer. In particular, a further data set is determined, which represents the model or its segments. Preferably, software is used to perform a non-overlapping decomposition of the overall model into the segments or partial models. However, it may also be advantageous to provide an overlap region between different structural segments or to provide an overlap on the periphery (surface) of the segments. In the overlap region, a smooth transition can be achieved in the manner described by varying the exposure dose. Overall, a data set representing the overall model is provided in a computing device with processor and memory and is stored in a memory. From this, further data records are determined by means of the computing device and are also stored in the memory. Preferably, when determining the further data set, a grid accuracy is used, with which the overall structure is approximated, with the spacing within the grid being configurable to better suit the application.

In the next step (c), a set of starting values for the Multi-Photon Lithography fabrication parameters is provided with which the fabrication process is started. Typical starting values mainly comprise laser excitation intensity (power), laser-scanning velocity (speed) and the objective lens to be used, and/or the modulated pulse rate and/or the modulated pulse length of the laser beam, among others. Usually, only a small number of sets, i.e. of power-speed combinations are used which are associated with different fabrication qualities. For example, 3, 4 or 5 (usually not much more) starting sets are defined per lens, each set representing a predefined profile, where one profile corresponds to the combination of laser power and scanning speed that translates into small voxels for detailed structures, another corresponds to the combination that enables to fabricate larger/bigger structures much faster and the remaining profiles strike a balance between these two. Before starting the replication process, a decision is made which one of the predefined sets of starting values is used as the first set with which the process is started (= the first set of values for the MPL fabrication parameters).

In the next step (d), a photoresist is casted or coated onto a substrate, thereby providing a volume of the photoresist. Typically, the photoresist is a monomer- or oligomer-based compound (for negative photoresists) or epoxide-based compound (for positive photoresists) with photo-absorbing and reaction-starting components. The monomer-/oligomer-based or epoxide-based compound with photo-absorbing components basically refers to substances whose chemical and/or physical material properties can be changed by irradiation with a laser writing beam, for example, which are known as lithography resists. Depending on the nature of the changes induced by the writing beam, lithography materials can be classified as so-called negative resists (where irradiation causes local hardening or insolubility in a developing medium) and in so-called positive resists (where irradiation locally increases the solubility in a developing medium). In general, such resists are well known. In a preferred embodiment the photoresist comprises a monomer-, oligomer- or epoxide-based compound in admixture with a photo-initiator, but may comprise further components such as co-initiators, further functional components, etc. It is essential that either the monomer-, oligomer-, or epoxide-based compound and/or the photo-initiator, comprises a light emitting component, preferably a component comprising a fluorophore group and/or that in addition to the monomer-, oligomer- or epoxide-based compound, and optionally the photo-initiator, a further compound is added, which comprises a light emitting group, preferably a fluorophore group with a response that is sensitive to the corresponding modification of the medium, e.g. the occurrence of polymerization. Non-limiting examples of compounds that comprise a light emitting group, preferably a fluorophore group are 7-Diethylamino-3-thenoyl-coumarin (DETC), trans,trans-1,4-bis[2-(2',5'-dimethoxy)phenyl-ethenyl)-2,3,5,6-tetrafluorobenzene or 7-Dimethylamino-4-trifluoromethyl-coumarin and 4- Dimethylamino-4'-nitrostilbene. In any case, the composition making up the photoresist must be capable of generating a light signal, preferably a fluorescence signal and, specifically, the photoresist must be capable of being modified during the polymerization process in such a way that the light, preferably fluorescence, emission of the components of the photoresist change, either in intensity or wavelength. This will cause the observed light, preferably fluorescence, signals to be specific to either the polymerized or the non-polymerized state of the photoresist. Examples of photoresist compositions which are compatible with this requirement are, for example, a photoresist composed of 7-Diethylamino-3-thenoyl-coumarin (DETC), or trans,trans-1,4-bis[2-(2',5'-dimethoxy)phenylethenyl)-2,3,5,6-tetrafluorobenzene, or 7-Dimethyl-amino-4-trifluoromethyl-coumarin or 4-Dimethylamino-4'-nitrostilbene or others as photo-initiator and Pentaerythritol triacrylate (PETA) or any other compatible polymerizable monomer as monomer.

All of the above described steps (a) through (d) are preparation steps, which are performed prior to the actual replication process. The sequence of steps in this preparation step are not critical and can deliberately be changed.

In step (e), the actual replication/fabrication process starts. Using the representation of the 2D or 3D model, i.e. the data set representing the overall model and the selected first set of values for the MPL fabrication parameters, the MPL excitation laser is directed and guided into and through the volume of the photoresist. Where and when the energy of the MPL excitation laser surpasses the polymerization threshold of the utilized photoresist, it triggers the polymerization process in the volume of the photoresist which has been affected by the laser. This usually occurs in the close vicinity of the laser focus, e.g. in a radius of ±1-5000 nm, preferably ±1-1500 nm depending on factors such as the numerical aperture of the objective lens, the used laser power, the photoresist composition, the considered axis (for standard MPL the elongation of the voxel in the Z axis is usually about 3x that of the XY axes, which is specified by the aspect ratio of the voxel) and the alignment of the optical components of the MPL equipment. The MPL excitation laser beam is a pulsed beam of laser light at a predefined wavelength and energy that is matched to the absorption spectra and absorption cross-section/polymerization threshold energy of the specific photoresist. Preferably, the MPL excitation beam is formed as a train of modulated laser pulses having a modulated pulse energy and a modulated pulse length. In order to modulate the energy deposition in the close vicinity of the voxel, the pulse energy and the scanning speed, which controls the amount of time a given volume is exposed to the laser beam (yielding a time averaged exposure dose), are both modulated. Other parameters can be modulated in order to modulate the energy deposition, such as the laser pulse length and the laser pulse rate, which may be defined at the laser source or by a modulator element located past the laser. The modulated pulse rate denotes in particular the number of modulated pulses per time unit, and the modulated pulse length denotes in particular the duration of the irradiation per pulse. The pulses of the laser excitation beam can be affected, for example, by modulating the intensity of the laser, for example by means of an acousto- or electro-optical modulator. Yet, modulating the energy deposition via the laser pulse length and the laser pulse rate is usually less practical, i.e. more complicated to implement and control, or more expensive and thus less preferred. As a practical, non-limiting example, e.g. when using a solution of DETC in PETA monomers as the photoresist formulation, laser powers in the range of 0.1-80mW, preferably in the range 1-50mW, more preferred in the range 5-30mW and scanning speeds in the range of 10-20000 µm/s, preferably in the range 50-12000µm/s, most preferable in the range 80-12000µm/s being preferred. Either one or more modulated laser pulse(s) can be used in each case for "writing" a volume element, either in a single or several scan passages, as long as enough cumulative energy is absorbed by the photoresist to undergo significant polymerization.

It is possible to parallelize this fabrication step by implementing multi-focus MPL (= more than one excitation laser beam), where components such as acousto-optic deflectors, spatial light modulators, or digital micro-mirror devices, among others, are used to generate multiple focus points through dynamic and configurable light splitting. Such multiple focus points are usually used to fabricate multiple replicas of the same structure side by side and are most beneficial in large-scale production of the fabrication of large periodic structures. In this configuration, each focal spot effects a different volume of photoresist, parallelizing the fabrication process without interaction between the foci.

The core process step (f) in the present invention is that the volume of the photoresist which has been affected by the beam(s) of the excitation laser in step (e), and its vicinities, are scanned with a second laser, the characterization laser, between 0 and 10000000µs, preferably 100 and 400000 µs, most preferably between 200 and 100000 µs after excitation with the excitation laser. The characterization laser preferably scans at a predefined intensity dependent on the utilized photo-initiator, thereby triggering light, preferably fluorescence, signals in the volume of the photoresist which has been affected by both the excitation laser (above the polymerization threshold) and the characterization laser. As a practical, non-limiting example, when using a solution of DETC in PETA monomers as the photoresist formulation, characterization laser powers in the range of 0.1-100mW, preferably in the range 1-80mW, more preferred in the range 5-70mW are used. This enables the operator, or corresponding control program, to view and inspect (control and verify) the area where polymerization occurs almost simultaneously with the occurrence of polymerization.

In step (g), the light, preferably fluorescence signal, emitted in step (f) is registered, i.e. stored as data on a data carrier or in a volatile memory device together with at least the coordinates of the location of emission yielding in registered light signal data.

In step (h), the volume of polymerized photoresist is determined/inferred based on the registered light, preferably fluorescence signal registered in step (g). For this determination an analysis is used which correlates quantities such as the absolute and/or local intensity of the light, preferably fluorescence signal, the local rate of change, etc., to the polymerized volume. The parameters for this correlation depend on the monomer/oligomer used in the photoresist, the utilized photo-initiator and potentially on the excitation energy dose and/or the utilized polymerization sensitive fluorophore, in the case where the latter is not part of the monomer/oligomer or the photo-initiator. This correlation can easily be defined/calibrated in a limited number of test runs. As an example, a calibration structure with reoccurring features can be fabricated at varying energy doses (increased laser power, decreased scanning speed or even decreased spacing between parallel scanning lines), slightly varying its dimensions as well as the resulting light, preferably fluorescence signal, which can then be calibrated to a high-resolution measurement method, e.g. SEM, so as to provide a reliable measurement/determination of the resulting polymerized structure. This process aims to characterize both the infill and the outer boundaries of a fabricated structure. Such calibration must, of course, account for process specific parameters such as the structural shrinking during development or the thickness of the layer deposited onto the structure.

In step (i), the area and/or volume of polymerized photoresist determined in step (h) is compared with the corresponding area/volume in the utilized representation of the model (see Figure 1). Given a representation of the desired model and the determined/inferred equivalent representation of the fabrication result (the processed registered light signal data), the two can be compared and the degree of fidelity determined with the aid of a large set of evaluation parameters. Among such evaluation parameters are, for example, the area of both the replica and that of the to be replicated model (compared e.g. through their ratio or the minimum % of reproduced volume/area), the location of their boundaries (compared e.g. through the distance between the location of the boundary in the model and in the replica or the difference in the distance between two closely located boundaries in the model and the replica), the existence of un-polymerized areas in the infill of the fabrication result which are not present in the to be replicated model and so on. Based on such evaluation parameters, a threshold or set of thresholds can be defined which enables one to classify the achieved reproduction result as either a satisfactory or a non-satisfactory reproduction (see Figure 1).

In step (j), the first set of values for the MPL fabrication parameters is
- adjusted if the comparison in step (i) is non-satisfactory, yielding in an adjusted set of values for the MPL fabrication parameters; or
- maintained if the comparison in step (i) is satisfactory.

Adjusting the first set of values comprises changing one or more of the parameters of the first set of values, e.g. the excitation intensity (power) and/or laser scanning velocity (speed), and/or modify the representation of the section to be exposed in the following step and/or other parameters of the first set of values. For example, if the verification and comparison of the polymerized area results in the polymerized area being smaller than the corresponding area of the representation of the 2D or 3D model, e.g. the excitation intensity (power) may be increased and/or the laser scanning velocity (speed) reduced, and/or the representation of the following section of the volume modified (see Figure 1); in any case a set of values should be selected which would result in an increase in polymerized volume compared to the controlled/verified volume in step (h). Likewise, if the verification and comparison results in the polymerized volume being larger than the corresponding volume of the representation of the 2D or 3D model, e.g. the excitation intensity (power) may be lowered and/or the laser scanning velocity (speed) increased; in any case a set of values should be selected which would result in a decrease in polymerized volume compared to the controlled/verified volume in step (h).

In the last step (k) steps (e)-(j) are recursively performed with either the adjusted set of values which would then replace the first set of values in step (e) or with the maintained (first) set of values and the next incremental data set of the representation of the 2D or 3D model adjacent to the data set just previously replicated, so as to progressively direct and guide the beam of the excitation laser into and through the volume of the photoresist until the model has been replicated.

Since the execution of the multi-photon lithography process is time consuming, usually involving scanning more than hundreds of thousands of lines or positions over hundreds and even thousands of layers or other equivalent partial representation components, the expenditure of time for any new, additional step, such as the scanning of the layer or component with the characterization laser and the processing of the resulting data, is cumulative as it will add significant time to the fabrication process and can possibly make the process impractical or even unfeasible, specifically for a scaled up manufacture for high numbers of replicas. Therefore, and although the impact varies for different fabrication processes, it is desirable to speed up the data processing step, which should not take longer than a few tens of milliseconds so as not to greatly impact the overall fabrication time. Moreover, it has to be taken into account that, in the above described real-time characterization process, only partial characterization data is available, since not all of the contiguous layers or components of a given layer or component can be accounted for because they are yet to be exposed. Typically, it is not possible to account for the effect of layers above a layer, which is just characterized because this layer is yet to be exposed. Therefore, it is beneficial to minimize the duration of the real-time analysis, typically by minimizing the amount of characterization data - usually only that of a given layer or representation component - and the complexity of the analysis for the real-time characterization and parameter control.

While this alleviates the impact on the fabrication time, it is bought at the expense of some error by not accounting for proximity effects between contiguous layers or representation components. Yet, once the fabrication of a replica is finished, the data for all the fabricated layers or components are available and the processing time is no longer a factor. This means that the characterization data can now be processed to increase precision, accounting for proximity effects and generating even more reliable results, which can then be used to improve future, maybe even up-scaled, fabrication processes. Therefore, in a further embodiment the present invention also provides a solution for increased replica precision by using the data acquired during the above described real-time improved fabrication in a data-driven automated reproduction process for high-resolution 3D samples.

### Detailed description of the high-resolution 3D reconstruction process

In step (i), of the high-resolution 3D reconstruction process, the complete set of registered light signal data obtained in step (g) of the above described real-time verification process, a set, which corresponds to a single complete replica, is loaded, i.e. partially or totally placed in a volatile memory device that enables further processing and analysis of the previously acquired data. This step should occur after the fabrication of the whole replica in the real-time verification process is completed, as it better represents the full structure by utilizing all its corresponding data.

In step (ii), the location where the photo-polymerization has been started is determined from the light, preferably fluorescence signal, loaded in step (i). For the light, preferably fluorescence signal, to be useful in this process, it has to be related to the material modifications caused by the photo-polymerization process. Therefore, the light, preferably fluorescence, data loaded in (i) are separated from the background and other sources of error through an analysis based on quantities such as the absolute and/or local intensity of the light, preferably fluorescence signal, the local rate of change, etc. The parameters for this analysis depend on the monomer/oligomer used in the photoresist, the kind/type of photo-initiator used, the acquisition sensor and potentially on the excitation laser energy dose and/or the polymerization sensitive fluorophore, in the case where the latter is not part of the monomer/oligomer or the photo-initiator.

In step (iii) the photo-polymerized volume, and possibly its degree of polymerization, is determined/inferred at each spatial location from all the contributions over the whole structure of the replica. By taking into account all the points that undergo polymerization and all the exposures that contribute to the polymerization process, the total polymerized volume corresponding to the complete fabricated structure of the replica can be estimated. The method applied in this step improves on the method utilized in step (h) of the previously described real-time verification process by taking into account not only the data of a single material section, the one including the point where the laser focus center point coincided with that point being evaluated, but also the exposition of material in all other structural sections that are in close vicinity and which may have influenced the occurrence of polymerization in the evaluated location. That is, the polymerized volume is determined or inferred at each position by taking into account all the overlapping laser exposition and polymerization proximity effects within all sections of the replica. This is important since, for example, the exposition of a layer of material whose features partially overlap with those of another layer results in larger polymerized features due to cumulative exposition or 'memory' effects, compared to a layer which is exposed in suspension only and with minimal contact to anything else.

For this purpose, the signal from step (ii), that is proportional to the degree or the overall occurrence of polymerization, is analyzed, and quantities such as the absolute and/or local intensity of the light, preferably fluorescence signal, the local rate of change, etc., evaluated over a significant vicinity of each point and for all the accumulated exposures over the whole fabrication, are correlated to the final polymerized volume. The conversion from the light, preferably fluorescence signal, to the corresponding locally polymerized volume is not immediate since the polymerized volume can grow, e.g. through thermally-driven molecular diffusion around regions exposed to the laser or just due to the chain-addition of monomers during the polymerization; but also shrink, e.g. during development, but such parameters can be estimated from the fabrication of test structures and their characterization, as explained next.

The parameters for the correlation between the signal obtained in (ii) and the total resulting fabricated volume depend on the monomer/oligomer used in the photoresist, the kind/type of photo-initiator used and potentially on the excitation energy dose and/or the utilized polymerization sensitive fluorophore, in the case where the latter is not part of the monomer/oligomer or the photo-initiator. This correlation can easily be defined/calibrated in a limited number of test runs. As an example, a calibration structure with reoccurring features can be fabricated at varying energy doses (increased laser power, decreased scanning speed or even decreased spacing between parallel scanning lines), slightly varying its dimensions as well as the resulting fluorescence signal, which can then be calibrated against a high-resolution measurement method, e.g. SEM, so as to provide a reliable measurement of the resulting polymerized structure. This process aims to characterize both the infill and the outer boundaries of a fabricated structure. Such calibration must, however, take into account process specific parameters such as the structural shrinking during development or the thickness of the layer deposited onto the structure.

In step (iv), the fidelity and structural integrity of the fabricated replica is inferred based
- on the 2D or 3D representation of the model, used for its fabrication,
- the signal from step (ii) referring to the regions where the photo-polymerization was started and
- the exposure accumulation referred to in (iii) over all regions.

Given the representation of the model utilized for fabrication and the determined/inferred comprehensive representation of the fabrication result performed in step (iii), the two can be compared by a large set of evaluation parameters, as appropriate to the objective of the structure, and it is possible to identify areas or volumes where the replication process was not satisfactory, e.g. either due to inexistent or excessive polymerization volumes. Among such evaluation parameters are, for example, the volume of both the replica and that of the model (compared e.g. through their ratio or the minimum % of reproduced volume/area), the location of their boundaries (compared e.g. through the distance between the location of the boundary in the model and in the replica or a sufficient separation distance between two closely located boundaries in the model and the replica), the existence of un-polymerized areas in the infill of the replica which are not present in the model and so on.

Furthermore, in cases where the intensity of the signal in step (ii) is proportional to the degree of photo-polymerization, as for the case of the PETA-DETC photoresist, this analysis can be further extended to account for increased shrinking during development or local variations of the material mechanical properties and an evaluation of their impact on the final replica. In this case, the data from step (iii) can be used to estimate relevant physical parameters, e.g. mechanical strengths of the material, or their relative deviation to a given standard value, and simulations can be performed to assess the impact of such variations in the replica. This analysis can be calibrated by deliberately decreasing the exposition values utilized in a sequence of structures until the replica is seen to collapse, although this cannot be done very precisely due to the difficulty of estimating the conditions during the development step.

In step (v), the data from steps (iii) and (iv), which can be represented, for example, by a set of points in 3D space where polymerization has occurred and a set of 2-3 numbers corresponding to the radius of polymerized volume along each axis around that point, is expanded in a 3D representation. "Adding-up" all these small volumes enables one to determine a complete volumetric "representation of the replica" and, perhaps more importantly, enables one to determine the outer and possibly also the inner surface(s) through surface reconstruction methods. This yields in a much lighter 3D representation or reconstruction of the fabricated replica than the data generated in the real-time verification process.

Once the resulting replica surface(s) are determined, any feature dimension or any distance between features can immediately be determined in 3D, within the precision of the specific signal acquisition method used (see section Advantages of the Invention), by using an appropriate external software. Such method avoids error sources such as perspective errors and occlusions or sample deformation that can be significant, for example, in SEM.

In step (vi), by generating data corresponding to the ones loaded in step (i), associated with the fabrication parameters and sufficient external characterization of the replica, e.g. by SEM or the method in step (v), for which a good calibration is assumed, it is possible to anticipate the optimal progression of fabrication settings for features of a particular shape or other variations such as diffusion over increased laser focus depths. "Optimal progression" here means the variation of fabrication parameters over one or several sections of the replica, which varied parameters lead to an improved fidelity or decreased error between the final fabricated replica and the model. This is particularly applicable in the context of machine-learning systems and algorithms where it is conceivable that a system can be trained to receive the initial model and an initial set of fabrication parameters and output an adjusted set of fabrication parameters for each structural section of the replica, and possibly even modified representations for each structural section of the replica to be fabricated, that result in an overall replica that more closely resembles the model. While in the step (j) of the initial real-time verification_process the alterations to the fabrication parameters are done reactively, i.e. based on a measured deviation from the model, the modifications to the fabrication parameters in this reproduction process for high-resolution 3D samples are performed preemptively and justified by the accumulated knowledge of a large set of past fabrication processes and their data.

In step (vii), physical properties of the fabrication process that lead to errors or deviations in the final replica, e.g. the structural shrinking during development of the sample or the diffusion length of the polymer chains during fabrication, and the fabrication and characterization data sets of previous fabricated structures are taken into account for the generation of an optimized representation of the replica, with an optimized representation being one that is achieved by a modification of the input-representation in this step (vii) and leads to a higher fidelity or reduced errors or deviations between the replica and the model.

The process stated in this step is very similar to that of step (f) in the first real-time verification_process but it acts on the structural representation utilized in the fabrication rather than the remaining fabrication parameters, which are more associated with the exposure of the material. It is also particularly relevant in the context of machine learning as a system can be trained, based on previous fabrication and characterization data, to convert the model into a representation of it that produces a more closely resembling replica than the exact decomposition of the original model. As an example, the fabrication of closely packed features (e.g. less than 200nm apart) is usually complicated due to the resolution of the fabrication method, but under certain conditions it is possible to achieve the desired result by scaling the representation of the model along a single particular axis by an amount that is proportional to the fabrication parameters. Performing this adjustment manually is hard and time-consuming but it is achievable with the present method, providing characterization data with sufficient precision are available, and by application and training of machine learning methods.

### Advantages of the Invention

The technical components' setup for the method according to the invention is highly compatible with MINFLUX (Gwosch, K.C., Pape, J.K., Balzarotti, F. et al.: MINFLUX nanoscopy delivers 3D multicolor nanometer resolution in cells, Nat Methods (2020); DOI: [10.1038/s41592-019-0688-0]), which enables one to characterize a structure in 3D down to a resolution of a few nanometers in each axis. This offers great advantages over the standard procedure of SEM based characterization as it enables higher resolution characterization without damaging the sample or requiring an extra coating, which can itself introduce a few nm error in the characterization of the sample due to heterogeneous coatings.

Using the characterization data acquired during the real-time verification procedure, the invention also enables one to provide a full 3D digital reconstruction of the replica with the same resolution as the real-time verification within a few minutes up to a few hours after the whole structure has been fabricated with the real-time verification procedure, depending on the complexity of replica. For comparison, an SEM characterization session usually takes one to several hours or even days for a partial characterization, depending on the complexity of the sample. Yet, the full 3D reconstruction process differs from the real-time verification process in as much as the real-time verification process only accounts for a very small subset of the whole data, usually only the data regarding the last layer or segment of exposed material (because the reconstruction should be as fast as possible, preferably faster than 100 ms, so as not to delay or influence the whole process), and does not, for example, account for all the proximity effects arising from scanning several closely spaced areas or segments. The real-time verification process should be taken as a local and fast reconstruction while the full 3D digital reconstruction should be taken as global reconstruction that aims for high fidelity.

Moreover, the present method offers definite advantages in the optimization of fabrication parameters for new structures because, instead of requiring wide-range parameter sweeps with posterior characterization, the present method enables one to assess on-the-fly how each layer of the fabricated structure compares with the model layer, enabling a faster convergence to the optimal fabrication parameter workspace.

Further, it has long been known that, as the laser is focused deeper within the sample, the increase in dispersion requires an increase in the laser power, or a decrease in the scanning speed, so as to maintain the fabrication running and uniform over the whole height range. While this is usually calibrated based on SEM analysis and implemented as a linear increase of laser power with the depth of focus inside the sample, with the method according to the present invention it is possible to automatically compensate such a dispersion based on direct readings of the light, preferably fluorescence, signal instead. In preliminary experiments such compensation has been seen to depend on the structure, therefore presenting different progressions over the structure height.

## Claims

1. Multi-Photon Lithography process, comprising
- directing and guiding a beam of an excitation laser into and through a volume of a photoresist in order to trigger a polymerization process in the volume of the photoresist which has been affected by the beam of the excitation laser, wherein the photoresist comprises a light-emitting material that is sensitive to changes in the volume that occur during photo-polymerization;
- scanning the volume of the photoresist which has been affected by the beam of the excitation laser and its vicinities, between 0 and 10000000 µs after excitation with the excitation laser, with a second laser, thereby triggering the emission of light signals in the volume of the photoresist which has been affected by both lasers, and
- determining/inferring the volume of polymerized photoresist based on the intensity of the emitted light signals.

2. Real-time controlled and verified Multi-Photon Lithography process, comprising the steps:
a) providing a representation of a model to be replicated;
b) deconstructing the model to be replicated into a layer- or path-based representation;
c) providing a first set of values for the Multi-Photon Lithography fabrication parameters;
d) providing a photoresist casted or coated onto a substrate, thereby providing a volume of the photoresist wherein the photoresist comprises a light-emitting material, that is sensitive to changes in the volume that occur during photo-polymerization;
wherein the sequence of steps a)-d) can deliberately be changed;
e) using the layer- or path-based representation of the model and the first set of values for the MPL fabrication parameters to direct and guide a beam of an excitation laser into and through the volume of the photoresist as claimed in claim 1;
f) scanning the volume of the photoresist which has been affected by the beam of the excitation laser in step e) and its vicinities as claimed in claim 1;
g) registering the light signals together with at least the coordinates of their location of emission yielding in registered light signal data;
h) determining/inferring the volume of polymerized photoresist based on the intensity of the registered light signal as claimed in claim 1;
i) comparing the volume of polymerized photoresist determined in step h) with the corresponding volume in the layer- or path-based representation of the model, resulting in a satisfactory or a non-satisfactory reproduction of the volume;
j) adjusting the first set of values for the MPL fabrication parameters if the comparison in step i) is non-satisfactory, yielding in an adjusted set of values for the MPL fabrication parameters; or maintaining the first set of values for the MPL fabrication parameters if the comparison in step i) is satisfactory;
k) recursively performing steps e)-j) with either the adjusted set of values for the MPL fabrication parameters or the maintained set of values for the MPL fabrication parameters and the next incremental data set of the representation of the model adjacent to the data set just previously replicated so as to progressively direct and guide the beam of the excitation laser into and through the volume of the photoresist until the model has been replicated.

3. Data-driven full 3D reconstruction and modelling of a multi-photon lithography fabrication process, comprising the following steps:
i. loading characterization light signal data acquired during the recursive registration in step g) of the process steps e) through j) of claim 2 for a model;
ii. determining points where the polymerization process was started in step e) of claim 2;
iii. determining/inferring the total polymerized volume, accounting for proximity effects of several polymerization starting points on the same region in step e) of claim 2;
iv. identifying points where the polymerization did not occur to a sufficient extent to generate the desired geometry or led to weaker regions in the final structure;
v. reconstructing the model of the final replicated model in step k) of claim 2, based on the analysis on iv.) by generating a 3D map of fabricated points and reconstructing a mesh over these points;
vi. identifying and interpreting common light signal responses and their common progression over several layers or path-based representations in step f) of claim 2 and evaluating the results of the correction strategies applied to the set of fabrication parameter values;
vii. identifying/determining fabrication characteristics such as diffusion lengths, aspect ratio and others and tune/generate new deconstruction algorithms to account for such characteristics and ensure better fabrication fidelity and reproducibility of the 3D replica.

4. Process according to claim 1 or 2, wherein the photoresist is a positive or negative photoresist.

5. Process according to claim 1, 2 or 4, wherein the light emitting material is a fluorescent compound, which exhibits polymerization sensitive fluorescence, in such a way that a different fluorescence signal can be registered depending on whether it is emitted from a polymerized or non-polymerized region.

6. Process according to claim 1, 2, 4 or 5, wherein the excitation laser beam is formed as a train of modulated laser pulses.

7. Process according to one of claims 1-2 or 4-6, wherein the characterization laser beam is a pulsed or continuous wave beam of laser light with an irradiance that is able to promote photon emission, preferably through excitation of a fluorescent transition in the photoresist volume that was excited and modified by the excitation beam.

8. Process according to claim 2, wherein in the deconstruction the model is sliced or decomposed in a number of coplanar layers or a set of 3D lines, or any other equivalent representation, with information of the intersection of each of these layers or lines and the desired model and the distance between the layers in the former case.

9. Process according to claim 1 or 2, wherein the excitation laser beam triggers polymerization in a volume of the photoresist, which has been affected by the laser including the close vicinity of the laser focus in a radius of ±1-5000 nm, preferably ±1-1500 nm.

10. Process according to one of claims 1-2 or 4-9, wherein the characterization laser has a power in the range of 0.1-100mW, preferably in the range 1-80mW, more preferred in the range 5-70mW.

11. Process according to one of claims 1-2 or 4-10, wherein the excitation laser has a power in the range of 0.1-80mW, preferably in the range 1-50mW, more preferred in the range 5-30mW

12. Process according to one of claims 1-2 or 4-11, wherein the excitation laser has a scanning speed in the range of 10-20000 µm/s, preferably in the range 50-12000µm/s, most preferable in the range 80-12000µm/s.

13. Process according to one of claims 1-2 or 4-12, wherein the volume of the photoresist which has been affected by the beam of the excitation laser in are scanned with the characterization laser, between 100 and 400000 µs, preferably between 200 and 100000 µs after excitation with the excitation laser.

14. Process according to one of claims 1-2 or 4-13, wherein the light emitting material is 7-Diethylamino-3-thenoyl-coumarin (DETC), trans,trans-1,4-bis[2-(2',5'-dimethoxy)phenyl-ethenyl)-2,3,5,6-tetrafluorobenzene, 7-Dimethylamino-4-trifluoromethyl-coumarin or 4- Dimethylamino-4'-nitrostilbene,
